# EUROPEAN PATENT SPECIFICATION

(11) **EP 2 703 446 B1**
(45) Date of publication and mention of the grant of the patent: **20.01.2016**
(21) Application number: 12776578.2
(22) Date of filing: 06.02.2012
(51) Int. Cl.: C08L 27/16, C08J 5/18, C08K 9/02, C08L 33/12, C08L 71/02, H01L 31/042

(54) **VINYLIDENE FLUORIDE-BASED RESIN FILM, SOLAR CELL BACK SHEET, AND SOLAR CELL MODULE**
HARZFILM AUF VINYLIDENFLUORBASIS, SOLARZELLENRÜCKSEITENFOLIE UND SOLARZELLENMODUL
FILM DE RÉSINE À BASE DE FLUORURE DE VINYLIDÈNE, FEUILLE ARRIÈRE DE CELLULE SOLAIRE, ET MODULE SOLAIRE

(30) Priority: 28.04.2011 JP 2011102402
(43) Date of publication of application: 05.03.2014
(73) Proprietor: Denka Company Limited, Tokyo 103-8338 (JP)
(72) Inventor: KOMODA Fukumu, Isesaki-City Gunma 372-0855 (JP); SUMINO Tatsunori, Isesaki-City Gunma 372-0855 (JP); NAKAJIMA Kohji, Isesaki-City Gunma 372-0855 (JP); AKIYAMA Kazuhiro, Machida-City Tokyo 194-8560 (JP)
(74) Representative: Smaggasgale, Gillian Helen
(86) International application number: PCT/JP2012/052635
(87) International publication number: WO 2012/147385

(56) References cited:
- EP-A1- 1 813 642
- EP-A1- 2 397 519
- WO-A1-2010/092942
- WO-A1-2011/065234
- WO-A1-2011/105515

## Description

### Technical Field

The present invention relates to a vinylidene fluoride-based resin film, a solar cell back sheet, and a solar cell module. More specifically, it relates to a vinylidene fluoride-based resin film comprising a vinylidene fluoride resin, a methacrylate ester resin, an inorganic pigment and others and a solar cell back sheet and a solar cell module comprising the film.

### Background Art

The surfaces of plastic plates, metal plates, and other various base materials used in materials for interior and exterior parts of buildings are coated or laminated with a resin film for protection, improvement of the weather resistance, decoration, and design of the base materials. Fluorine resin-based films superior in weather resistance have been used as the resin films in these applications and, in particular, vinylidene fluoride-based resin films are used frequently.

The vinylidene fluoride-based resin films are used not only in the applications described above but also in various other applications, for example, as wall papers and wall materials, interior and exterior materials of vehicles and elevators, roof material such as roofing tiles, rainwater gutters, motor garages, arcades, sun rooms, agricultural materials, tent cloths, signboards, sings and marks, labels, marking films, furniture, home appliances, trays, solar cells, and window glasses.

In addition, resin compositions or resin films containing a vinylidene fluoride resin and an inorganic pigment are known (see, for example, Patent Documents 1 and 2). In the resin composition described in Patent Document 1, a mixed oxide-based inorganic pigment is added as colorant to a resin composition consisting of a vinylidene fluoride resin and a methacrylate ester resin. Alternatively, Patent Document 2 discloses optical films having an ultraviolet-absorbing layer that comprises a fluorine resin such as polyvinylidene fluoride and inorganic fine particles of zinc oxide, titanium dioxide, or alumina.

On the other hand, fluorine resins, which are one of the resins having the lowest surface tension, have a problem that they are drastically less wettable to various substances and thus generate many defects in the film production process. Thus, proposed was a vinylidene fluoride-based resin film containing, as its inorganic pigment, titanium oxide carrying alumina and silica deposited on the surface for improvement of the dispersibility thereof in the resin in particular amounts (see Patent Document 3).

### Citation List

### Patent Literatures

[Patent Document 1] Japanese Unexamined Patent Application Publication No. H02-235953
[Patent Document 2] Japanese Unexamined Patent Application Publication No. 2006-18255
[Patent Document 3] WO 2010/092942

### Summary of Invention

### Technical Problem

However, the conventional technologies described above have the following problems: Fluorine-based resins containing an inorganic pigment, such as the films described in Patent Documents 1 and 2, have a problem that the pigment is less dispersible and often cause defects. When the inorganic pigment is less dispersible, it often generates pinholes during processing for example of a film and leads to deterioration of the thermal stability of the film during molding processing for example in the compounding and film-forming processes.

A polyethylene glycol fatty acid ester and/or the derivative thereof is added to the resin composition described in Patent Document 1 for improvement of the dispersibility of the inorganic pigment, but use of such a dispersant in a large amount leads to deterioration of the weather resistance and the physical strength of the resin film. Thus, addition of such a dispersant such as polyethylene glycol fatty acid ester is effective to resin films containing an inorganic pigment blended in a small amount, but in the case of resin films containing an inorganic pigment in a large amount, addition of a dispersant causes a problem that it cannot be added in the amount corresponding to the amount of the pigment added, i.e., in an amount sufficiently effective for favorable dispersion of the pigment.

In contrast, in the case of the vinylidene fluoride-based resin film described in Patent Document 3, the inorganic pigment is favorably dispersed therein and thus the resin film has a smaller number of pinholes caused by insufficient dispersion and is improved in thermal stability during molding processing, compared to conventional fluorine resin-based films. However, improvement of its thermal stability is further needed from the viewpoint of processability.

Accordingly, a major object of the present invention is to provide a vinylidene fluoride-based resin film resistant to pinhole generation caused by insufficient dispersion and superior in thermal stability during molding processing, even if it contains a pigment in a large amount, and a solar cell back sheet and a solar cell module comprising the same.

### Solution to Problem

The vinylidene fluoride-based resin film according to the present invention is a vinylidene fluoride-based resin film comprising a vinylidene fluoride resin, a methacrylate ester resin, titanium oxide surface-treated with alumina, silica, and zirconia, and a polyethylene glycol fatty acid ester and/or the derivative thereof, wherein the total amount of the alumina, silica and zirconia deposited on the titanium oxide is 5 to 15 mass %, and the amount of zirconia deposited thereon is 0.5 mass % or more and less than 2.0 mass %. The amounts of alumina, silica, and zirconia deposited on the surface of the titanium oxide in the vinylidene fluoride-based resin film according to the present invention are values determined by X-ray fluorescence (XRF) analysis method.

As a titanium oxide carrying alumina, silica, and zirconia deposited in particular amounts on the surface is used as inorganic pigment in the present invention, the inorganic pigment can be dispersed favorably, even if its blending amount is increased.

The resin film may contain the titanium oxide in an amount of 10 to 25 parts by mass and the polyethylene glycol fatty acid ester and/or the derivative thereof in a total amount of 0.1 to 5 parts by mass with respect to 100 parts by mass of the resin component that consists of a vinylidene fluoride resin: 70 to 95 mass % and a methacrylate ester resin: 5 to 30 mass %.

In this case, the titanium oxide content may be 12 to 20 parts by mass.

Alternatively, the total amount of alumina, silica and zirconia deposited on titanium oxide may be 6 to 12 mass %.

Yet alternatively, the titanium oxide having amounts of alumina and silica deposit thereon respectively of 2.5 mass % or more and an amount of zirconia deposited thereon of 1.0 mass % or more and less than 2.0 mass % may be used.

Yet alternatively, the titanium oxide may be additionally surface-treated with an organic matter.

The solar cell back sheet according to the present invention is prepared, using the vinylidene fluoride-based resin film described above.

The solar cell module according to the present invention is also prepared, using the solar cell back sheet.

### Advantageous Effects of Invention

According to the present invention, a titanium oxide carrying alumina, silica, and zirconia deposited in particular amounts on the surface is used as inorganic pigment and thus, the inorganic pigment is favorably dispersible in the resin component containing a vinylidene fluoride resin as the principal component. The resin film has fewer pinholes and is more thermally stable during molding processing, even when the inorganic pigment is blended in a larger amount.

### Description of Preferred Embodiments

Hereinafter, favorable embodiments of the invention will be described in detail. The embodiments described below are provided only for description of typical embodiments of the present invention and not intended to restrict the scope of the present invention.

### (First embodiment)

First, a vinylidene fluoride-based resin film in the first embodiment of the present invention (hereinafter, referred to simply as the resin film) will be described. The resin film in the present embodiment comprises at least, a resin component consisting of a vinylidene fluoride resin and a methacrylate ester resin, titanium oxide, and a polyethylene glycol fatty acid ester and/or the derivative thereof.

The titanium oxide blended to the resin film in the present embodiment is surface-treated with alumina, silica, and zirconia and the total amount of them deposited is 5 to 15 mass % and the amount of zirconia deposited is 0.5 mass % or more and less than 2.0 mass % with respect to the total mass of the titanium oxide. The "total mass of titanium oxide" is the mass including the alumina, silica, and zirconia deposited on the surface. Hereinafter, each of the components for the resin film in the present embodiment will be described.

### [Vinylidene fluoride resin]

The vinylidene fluoride resin is the principal component of the resin film in the present embodiment which is superior in weather resistance and heat resistance. The vinylidene fluoride resin blended in the resin film of the present embodiment is not particularly limited in its structure, if it is a vinyl compound containing a vinylidene fluoride monomer unit and may be a homopolymer of vinylidene fluoride or a copolymer of vinylidene fluoride and other vinyl compound monomers.

The vinyl compounds to be copolymerized with the vinylidene fluoride include, for example, fluorinated vinyl compounds such as vinyl fluoride, tetrafluoroethylene, trifluorochloroethylene, and hexafluoropropylene, and known vinyl monomers such as styrene, ethylene, butadiene, and propylene.

### [Methacrylate ester resin]

The methacrylate ester resin, which is a component constituting the resin component with the vinylidene fluoride resin, is effective in improving the adhesiveness, for example, to base materials. The vinylidene fluoride resin is less adhesive to other raw materials, but becomes more adhesive without addition of an expensive adhesive agent, if it is blended with the methacrylate ester resin.

The methacrylate ester resin blended in the resin film of the present embodiment is not particularly limited in its structure, if it is a vinyl polymer based on a methacrylate ester monomer. Examples of the methacrylate ester monomers include methyl methacrylate, ethyl methacrylate, propyl methacrylate, butyl methacrylate, pentyl methacrylate, and hexyl methacrylate, and the like, and in particular, methyl methacrylate is preferable. The alkyl group, such as propyl, butyl, pentyl, or hexyl, in the methacrylate ester monomer may be linear or branched.

The methacrylate ester resin blended in the resin film of the present embodiment may be a homopolymer of the methacrylate ester monomer or a copolymer of multiple methacrylate ester monomers. Alternatively, the methacrylate ester resin may contain monomer units derived from known vinyl compounds such as styrene, ethylene, butadiene, α-methyl styrene, acrylonitrile, acrylic acid, and propylene in addition to the methacrylate ester-derived units.

### [Blending ratio of resin component]

The resin components in the resin film of the present embodiment are a vinylidene fluoride resin and a methacrylate ester resin, as described above, and the blending ratio thereof by mass is preferably: vinylidene fluoride resin: methacrylate ester resin = 70:30 to 95:5. When the blending ratio of the methacrylate ester resin is small and the blending ratio of the vinylidene fluoride resin is more than 95 mass % with respect to the total mass of the resin components, the resin may be thermally decomposed during molding processing and discolor into yellow or brown, thus prohibiting production of a film with desired color.

The term "molding processing" means a "compounding step" of mixing multiple raw materials, heating the mixture into the molten state and converting it into pellets with an extruder and a "film-forming step" of heating the resin pellets into the molten state in a film extruder, extruding it through a dice into the film shape and cooling and winding the resulting films. The same will apply in the following description.

Alternatively when the blending ratio of the methacrylate ester resin is large and the vinylidene fluoride resin ratio is less than 70 mass % with respect to the total mass of the resin components, the resulting film shows lower weather resistance and may not be resistant enough to discoloration, when used outdoor for an extended period of 20 years or more.

### [Titanium oxide]

The resin film in the present embodiment contains an inorganic pigment blended for absorption or reflection of ultraviolet ray and thus is colored in white. Specifically, the inorganic pigment contains a titanium oxide surface-treated with alumina, silica, and zirconia. The vinylidene fluoride resin, which is superior in weather resistance, has a weather resistance inherent to the resin film, but for use for example as a protective film, it should also prevent the material to be protected, which is placed below the lower layer, from exposure to ultraviolet ray. Thus in the resin film of the present embodiment, transmission of ultraviolet ray is prevented by light absorption or reflection by titanium oxide.

The titanium oxide in the resin film of the present embodiment is preferably a rutile or anatase crystalline product produced by the chloride or sulfate method. For example when titanium oxide is produced by the chloride method, TiCl₄ is oxidized to TiO₂ particles. Alternatively when the titanium oxide (TiO₂) is produced by the sulfate method, an ore containing sulfuric acid and titanium is dissolved and the solution obtained is converted to TiO₂ via a series of steps. Practically, use of a titanium oxide having a rutile-type crystal structure that is resistant to the discoloration due to deterioration of the weather resistance is desired.

The particle diameter of the titanium oxide, as determined by sedimentation method, is preferably 0.05 to 2.0 µm as the average particle diameter. It is because, when the titanium oxide particle diameter is less than 0.05 µm, the resulting film becomes transparent, as it permits transmission of visible light, and when the titanium oxide particle diameter is more than 2 µm, the particles are less easily dispersed in the resin and aggregate easily.

The "surface treatment" with alumina, silica, and zirconia means that alumina, silica, and zirconia are adsorbed on the surface of the titanium oxide surface or that at least one compound among the reaction products of alumina, silica, and zirconia with titanium oxide is present as the adsorbed species or chemically bound to the surface. Alumina, silica, and zirconia are present continuously or uncontinuously on the surface of such a surface-treated titanium oxide as a single-, double-, or triple-layered coat layer. Particularly preferable is a titanium oxide having silica as the first layer, alumina as the second layer, and zirconia as the third layer on the surface. The method of surface-treating titanium oxide with alumina, silica, and zirconia is not particularly limited and any known method may be employed.

### Total amount of alumina, silica, and zirconia deposited: 5 to 15 mass %

When the total amount of alumina, silica, and zirconia deposited is less than 5 mass %, the catalytic activity-reducing effect and the dispersibility of the titanium oxide in the resin component decline, prohibiting production of a resin film both with favorable weather resistance and thermal stability during molding processing. Specifically, when the amount of alumina deposited is smaller, the dispersibility of the titanium oxide in the resin components declines, leading to deterioration of the thermal stability during molding processing. Alternatively when the amount of silica deposited is smaller, the weather resistance of the film declines.

On the other hand, when the total amount of alumina, silica and zirconia deposited is more than 15 mass %, titanium oxide particles easily aggregate via the hydrogen-bonded water thereof, prohibiting production of a film with favorable appearance. Accordingly, the total amount of alumina, silica, and zirconia deposited is 5 to 15 mass % with respect to the total mass of titanium oxide. The total amount of alumina, silica, and zirconia deposited is preferably in the range of 6 to 12 mass %, from the viewpoints of thermal stability and dispersibility. Specifically, a total amount deposited of less than 6 mass % may results in a film with insufficient thermal stability, while a total amount deposited of more than 12 mass % may lead to decrease of dispersibility caused by the water contained in alumina, silica, and zirconia.

### Amount of zirconia deposited: 0.5 mass % or more and less than 2.0 mass %

Even when the total amount of alumina, silica, and zirconia deposited is 5 to 15 mass %, if the amount of zirconia deposited is less than 0.5 mass %, it is not possible to obtain these effects sufficiently. Alternatively if it is 2.0 mass % or more, the dispersibility may decline under the influence of the hydrogen-bonded water and physically adsorbed water in zirconia. Accordingly, the amount of zirconia deposited on the titanium oxide is 0.5 mass % or more and less than 2.0 mass %. It is possible in this way to reduce the catalytic activity of titanium oxide to the resin component and increase the dispersibility of titanium oxide, thus improving both the weather resistance and also thermal stability during molding processing of the resulting film.

### Amount of alumina and silica deposited: respectively 2.5 mass % or more, and amount of zirconia deposited: 1.0 mass % or more and less than 2.0 mass %

More preferably, the amounts of alumina and silica deposited with respect to the total mass of titanium oxide are respectively 2.5 mass % or more and the amount of zirconia deposited is 1.0 mass % or more and less than 2.0 mass %. When the amount of alumina deposited is 2.5 mass % or more, it is possible to increase the dispersibility of titanium oxide in the resin component further. Alternatively when the amount of silica deposited is 2.5 mass % or more, it is possible to improve the weather resistance of the resin film.

Further when the amount of zirconia deposited is 1.0 mass % or more and less than 2.0 mass %, the dispersibility of titanium oxide in the resin component is improved further and it is possible to improve the weather resistance and the thermal stability during molding processing of the film. As described above, when the total amount of them deposited is 5.0 mass % or more, it is possible to preserve the thermal stability favorably during the molding processing for example in the compounding and film-forming steps.

The amount of alumina, silica, and zirconia deposited with respect to the total mass of titanium oxide can be determined quantitatively by analyzing the elements deposited on the titanium oxide surface by the X-ray fluorescence (XRF) analysis method and calculating it from the measured results. Specifically, the contents of the elements titanium (Ti), aluminum (Al), silicon (Si), and zirconia (Zr) in the total mass of titanium oxide are determined quantitatively respectively by the X-ray fluorescence (XRF) analysis method and the masses (converted value) of respective metal oxides (TiO₂, Al₂ O₃, SiO₂, and ZrO₂) are calculated from the results.

If compounds of these elements other than the oxides are present on the titanium oxide surface, the abundance ratios of these compounds present on the surface is determined by X-ray photoelectron diffraction (XPS) and thus, the amounts of the oxides and other compounds can be analyzed quantitatively.

The titanium oxide may be additionally surface-treated with a silane-coupling agent, a silicone oil, or an organic substance such as polyvalent alcohol. It is thus possible to control aggregation of titanium oxide and improve the dispersibility thereof and thus to obtain a film having fewer defects in appearance.

Alternatively, the amount of titanium oxide blended in the resin film of the present embodiment is preferably 10 to 25 parts by mass, more preferably 12 to 20 parts by mass, with respect to 100 parts by mass of the resin component described above. When the amount of titanium oxide with respect to 100 parts by mass of the resin component is less than 10 parts by mass, a thin film having a thickness for example of 30 µm or less may become lower in absorption or reflection efficiency of ultraviolet ray and less weather-resistant. Alternatively when the titanium oxide content is more than 25 parts by mass, it is difficult to disperse the titanium oxide uniformly in the resin component and if it has a thickness for example of 30 µm or less, the resulting film may have a surface unfavorable in appearance.

The resin film in the present embodiment may contain an inorganic pigment such as zinc oxide, zinc sulfide, or barium sulfate in addition to the titanium oxide described above. In such a case, the total amount of the inorganic pigments including titanium oxide is desirably 10 to 30 parts by mass with respect to 100 parts by mass of the resin component.

Titanium oxides surface-treated for example with silica, alumina, and zirconia have been used in resin compositions for reflectors and others (see, for example, JP-A Nos. 2008-255338, 2009-179670, and 2010-270177). The titanium oxide used in these compositions may be effective in increasing heat resistance, if the amounts of alumina and silica deposited are increased, but in such a case, the amount of water contained in the alumina and the silica also increases and thus, the titanium oxide cannot be dispersed sufficiently in resin films containing a vinylidene fluoride resin as the principal component.

In contrast, as zirconia is deposited in addition to alumina and silica on the resin film in the present embodiment, it is possible to control the catalytic activity of titanium oxide without sacrifice of dispersibility thereof in the vinylidene fluoride resin and to reduce the risk of thermal decomposition during processing. Thus, it is possible to improve the thermal stability during processing further without sacrifice of favorable dispersibility, by using a titanium oxide surface-treated with alumina, silica, and zirconia.

### [Polyethylene glycol fatty acid ester and the derivative thereof]

Fluorine resins, which are a group of the resins having the smallest surface tension, are extremely lower in wettability with various substances. Thus when a pigment is blended in a large amount for coloring the film, it often leads to insufficient dispersion and causes defects such as pinholes during processing and molding of the film. Thus, the resin film in the present embodiment contains a polyethylene glycol fatty acid ester and/or the derivative thereof, which is superior in compatibility with fluorine resins, added for improvement of the dispersibility of the pigment (titanium oxide).

Examples of the polyethylene glycol fatty acid esters and the derivatives thereof include polyethylene glycol fatty acid monoesters such as polyethylene glycol monolaurate and polyethylene glycol behenate; polyethylene glycol fatty acid diesters such as polyethylene glycol dilaurate and polyethylene glycol distearate; and higher fatty acid alcohol or alkyl phenol polyethylene glycol monoether fatty acid esters such as polyethylene glycol monoethylphenol ether laurate and polyethylene glycol monopolyoxyethylene bisphenol A laurate ester; and the like.

The amount of the polyethylene glycol fatty acid ester and the derivative thereof added can be selected properly according to the blending amount of the inorganic pigment described above, but is preferably 0.1 to 5 parts by mass with respect to 100 parts by mass of the resin component. When the total amount of the polyethylene glycol fatty acid ester and the derivative thereof is less than 0.1 part by mass with respect to 100 parts by mass of the resin component, the inorganic pigment may not be dispersed favorably. Alternatively when the total content is more than 5 parts by mass with respect to 100 parts by mass of the resin component, the film may have lower physical strength and the inorganic pigment may aggregate, leading to insufficient dispersion.

The thickness of the resin film in the present embodiment is not particularly limited and may be selected properly, for example, according to the application. For example when it is used as a protective film, the thickness is preferably 10 to 100 µm.

The resin film in the present embodiment may contain, in addition to the components described above, other additives such as antioxidants, dispersants, coupling agents, heat stabilizers, surfactants, antistatic agents, anti-fogging agents, ultraviolet absorbents and others.

### [Production method]

Hereinafter, the method for producing the vinylidene fluoride-based resin film in the present embodiment will be described. In producing the vinylidene fluoride-based resin film in the present embodiment, first, resin components, a vinylidene fluoride resin and a methacrylate ester resin, are blended and kneaded with a titanium oxide surface-treated with alumina, silica, and zirconia and a polyethylene glycol fatty acid ester and/or the derivative thereof at a particular ratio.

Extrusion in molten state for example in a single-screw extruder may be used as the kneading method but, for improvement of the dispersion of the inorganic pigment, use of a high-speed-revolution and high-shear kneader is preferable. The kneader is, for example, a FCM-type kneader manufactured by Kobe Steel. It is possible with such a kneader to disperse the inorganic pigment efficiently and provide a raw film material (resin composition) in a favorable surface state.

Alternatively, part or all of the vinylidene fluoride resin and/or methacrylate ester resin used in kneading may be in the powder form; a high-kneading-efficiency biaxial extruder may be used for kneading; or the composition may be premixed in a high-speed-revolution mixer at high temperature and then kneaded in the molten state in a single-screw extruder. It is possible in this way to improve the dispersion of the inorganic pigment further.

The raw film material obtained (resin composition) is then melt-extruded into the film shape. The resin film in the present embodiment may be a single-layer or multilayer film and, for example in the case of a multilayered film, a coextrusion molding method may be used as the melt-extrusion molding method. Coextrusion molding methods using a T die, in which the resins are laminated in the molten state, as they are extruded from multiple extrusion molding machines, include a multi-manifold die method of molding multiple resin layers into the sheet shape and bonding the respective layers with each other by bringing them into contact with each other and a feed block method of mixing and adhering multiple resins with each other with a mixing device and molding the resulting mixture into the sheet shape. Any method may be employed as the method for producing the resin film in the present embodiment.

As described above in detail, as a titanium oxide carrying alumina, silica, and zirconia deposited in particular amounts on the surface is used as inorganic pigment in the vinylidene fluoride-based resin film in the present embodiment, it is possible to make it dispersed favorably in the fluorine resin, particularly in the vinylidene fluoride resin and to reduce the risk of thermal decomposition of the resin. It is thus possible to improve the thermal stability of the resin during processing.

As the vinylidene fluoride resin in the present embodiment is superior in dispersibility of titanium oxide, it is resistant to dispersion insufficiency and also to pinhole generation and deterioration of thermal stability during molding processing, even if the inorganic pigment (titanium oxide) is blended in a larger amount. For that reason, it becomes possible to add titanium oxide in an amount greater than before and thus to improve the efficiency of shielding ultraviolet or other ray significantly.

### (Second embodiment)

Hereinafter, the solar cell back sheet in the second embodiment of the present invention (hereinafter, referred to simply as back sheet) will be described. The back sheet in the present embodiment is prepared by laminating the vinylidene fluoride-based resin film in the first embodiment described above, for example, with an electrically insulating resin film such as polyethylene terephthalate (PET)-based film and boding them to each other.

These films can be bonded to each other with various adhesives. The other resin film such as a PET-based film is laminated on the back sheet for providing it with electrical insulation, shielding properties, and water vapor barrier properties (moisture resistance).

The back sheet in the present embodiment, which has a vinylidene fluoride-based resin film containing a titanium oxide carrying alumina, silica, and zirconia in particular amounts on the surface as inorganic pigment, is superior in the efficiency of shielding ultraviolet or other ray. In addition, as the titanium oxide carrying zirconia as well as alumina and silica deposited thereon is lower in catalytic activity than titanium oxide itself, the resin film containing the titanium oxide is superior in moisture and heat resistance and also in ultraviolet resistance to other titanium oxide-containing resin films and has improved long-term durability.

### (Third embodiment)

Hereinafter, the solar cell module in the third embodiment of the present invention will be described. The solar cell module in the present embodiment has a structure in which a transparent substrate such as of glass, a sealing material (for example a thermoplastic resin material sheet such as of ethylene vinyl acetate copolymer (EVA)), a photovoltaic element (photovoltaic cell) and a back sheet are laminated in that order and integrated for example under pressure and heat.

The solar cell module in the present embodiment has the back sheet in the second embodiment described above. In production of the solar cell module, a back sheet and a glass cell are laminated via a sealing material for example of EVA. The back sheet of the second embodiment used in the present embodiment can be bonded by pressing under heat at 100 to 150°C.

The solar cell module in the present embodiment, which has a vinylidene fluoride-based resin film containing a titanium oxide carrying alumina, silica and zirconia deposited in particular amounts on the surface as inorganic pigment, is superior in long-term durability and shows smaller deterioration in performance when used for an extended period of time.

### Examples

Hereinafter, the advantageous effects of the present invention will be described with reference to Examples and Comparative Examples of the present invention. First in the present example, resin films of inventive Examples 1 to 4 were prepared from the resin compositions having the compositions shown in the following Table 1. Specifically, a vinylidene fluoride resin, a methacrylate ester resin, a titanium oxide, and a polyethylene glycol (PEG) fatty acid ester were blended in a tumbler at the ratio shown in the following Table 1. The mixture was then kneaded in a biaxial extruder with screws having a diameter ϕ of 45 mm, to give a compound (resin composition). The compound was then processed in a film-forming machine having a coat-hanger die having a slit of 0.4 mm and a width of 400 mm, which is connected to a single screw extruder with a screw having a diameter ϕ of 40 mm, to give a resin film having the thickness shown in the following Table 1.

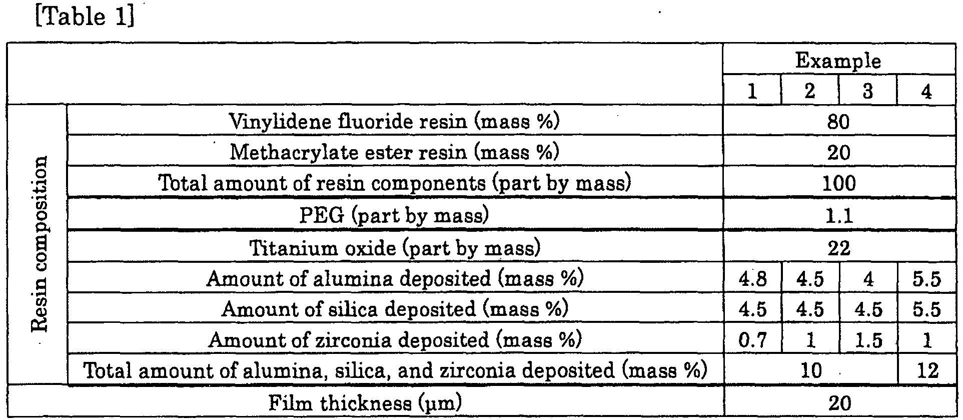

The vinylidene fluoride resin shown in Table 1 above was Kynar K720 from Arkema. The methacrylate ester resin used was HIPET HBS000 produced by Mitsubishi Rayon Co., Ltd. A titanium oxide carrying inorganic substances in the deposition amounts previously adjusted to those shown in Table 1 was used. Alternatively, the polyethylene glycol (PEG) fatty acid ester used was a polyoxyethylene bisphenol A laurate ester (Exceparl BP-DL manufactured by Kao Corporation) shown in the following Chemical Formula 1.

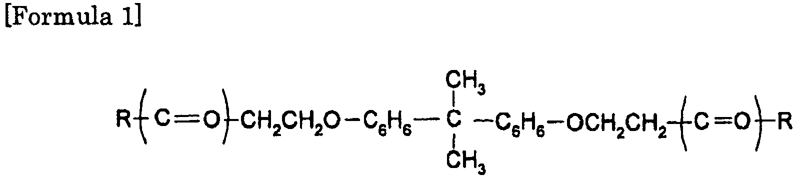

The amounts of alumina and silica deposited on each of the titanium oxides shown in Table 1 were determined by the following method. First, the elements deposited on the titanium oxide surface were identified by elemental analysis, using an X-ray fluorescence (XRF) analyzer Zsx100e produced by Rigaku Corporation. Then, the amounts of alumina, silica, and zirconia present on the titanium oxide surface were determined respectively by quantitative analysis of the titanium oxide particle surface by X-Ray photoelectron spectroscopy apparatus ESCA-5500MC manufactured by ULVAC-PHI, Inc. The amounts of alumina, silica, and zirconia deposited on each titanium oxide were calculated from these measurement results and also from the mass ratio of the oxides of respective elements (TiO₂, Al₂O₃, SiO₂, and ZrO₂).

As Comparative Examples 1 to 6 in the present invention, resin films were prepared from the resin compositions having the compositions shown in the following Table 2 by a method similar to that used in Examples 1 to 4 described above. As for the titanium oxide, a titanium oxide carrying inorganic substances in the deposition amounts previously adjusted to those shown in Table 2 was used.

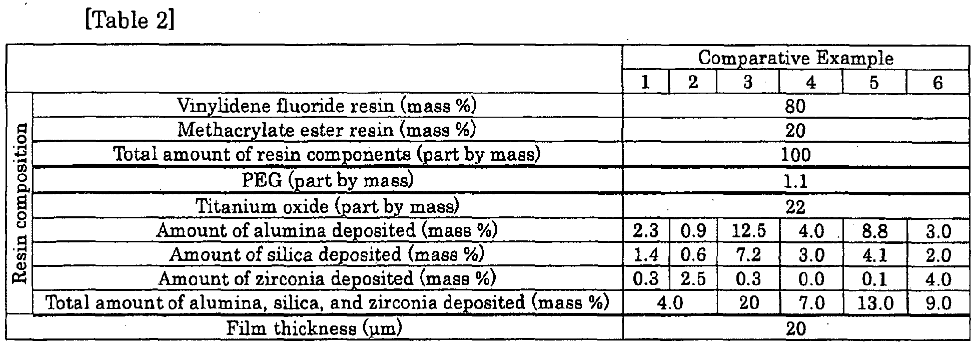

Subsequently, the pigment dispersibility and the thermal stability of the resin films of Examples and Comparative Examples were examined.

### <Pigment dispersibility>

The pigment dispersibility was evaluated, by counting the number of pigment agglomerates having an area of less than 0.05 mm² observed in a film area of 1 m² by visual observation, using a foreign-matter-identifying chart (JIS P8145), as the resin film was illuminated with light from the rear face. The pigment dispersibility of each film was evaluated, based on the results. A film with a pigment agglomerate number of less than 200 was indicated by "very favorable", that with a pigment agglomerate number of 200 or more and less than 400 by "favorable," and that with a pigment agglomerate number of 400 or more by "unfavorable."

### <Thermal stability>

The thermal stability was evaluated in the compounded state.
Specifically, (a) the thermal decomposition temperature and (b) the thermal decomposition time of the compounds having the compositions shown in Tables 1 and 2 above were determined by the following methods.

### (a) Thermal decomposition temperature

The thermal decomposition temperature was determined, using TG-DTA2000SA from Bruker AXS. A platinum pan was used then as the sample container and the amount of the sample used was approximately 1.5 mg. The measurement was performed in nitrogen environment after oxygen in the atmosphere was removed by vacuum evacuation. During measurement, the sample was heated from room temperature to 800°C at a heating rate of 10°C/minute. The temperature at which there was observed a weight loss by heating because of decomposition of the vinylidene fluoride resin was used as the thermal decomposition temperature of the sample.

After the measurement, a sample with a thermal decomposition temperature of lower than 350°C was indicated by "unfavorable", that of 350°C or higher and lower than 360°C by "good", that of 360°C or higher and lower than 370°C by "favorable", and that of 370°C or higher by "very favorable."

### (b) Thermal decomposition time

The thermal decomposition time was also determined, using TG-DTA2000SA from Bruker AXS. A platinum pan was used then as the sample container and the amount of the sample used was approximately 10 mg. The measurement was carried out under the temperature condition of 250°C for 24 hours, the carrier gas used was nitrogen and the flow rate of the carrier gas was 30 ml/min. The measurement was initiated after the atmosphere was substituted with nitrogen by vacuum evacuation. The point of inflection of the heating/weight loss curve, which derives from decomposition of the vinylidene fluoride resin, was used as the thermal decomposition time of the sample.

After measurement, a sample with a thermal decomposition time of less than 2.0 hours was indicated by "unfavorable," that of 2.0 hours or more and less than 3.0 hours by "good," that of 3.0 hours or more and less than 5.0 hours by "favorable", and that of 5.0 hours or more by "very favorable."

The results above are summarized in the following Table 3.

**[Table 3]**

| | Thermal stability | | | | Dispersibility | |
|---|---|---|---|---|---|---|
| | Decomposition initiation temperature (°C) | Rating | Decomposition starting time (h) | Rating | Number | Rating |
| Example 1 | 352.2 | Good | 3.2 | Favorable | 305 | Favorable |
| Example 2 | 364.1 | Favorable | 3.7 | Favorable | 158 | Very favorable |
| Example 3 | 386.7 | Very favorable | 5.2 | Very favorable | 256 | Favorable |
| Example 4 | 372.9 | Very favorable | 6.5 | Very favorable | 211 | Favorable |
| Comparative Example 1 | 342.5 | Unfavorable | 2.4 | Good | 456 | Unfavorable |
| Comparative Example 2 | 340.3 | Unfavorable | 1.8 | Unfavorable | 320 | Favorable |
| Comparative Example 3 | 370.3 | Very favorable | 4.7 | Favorable | 558 | Unfavorable |
| Comparative Example 4 | 352.8 | Good | 2.1 | Good | 189 | Very favorable |
| Comparative Example 5 | 360.8 | Favorable | 3.8 | Favorable | 468 | Unfavorable |
| Comparative Example 6 | 368.9 | Favorable | 4.9 | Favorable | 407 | Unfavorable |

As shown in Table 3 above, in Comparative Example 4 wherein a titanium oxide containing no zirconia component deposited thereon was used, the resin composition was less thermally stable. Alternatively in Comparative Examples 1 and 2 wherein a titanium oxide carried zirconia deposited thereon but had a total deposited amount of zirconia, alumina, and silica of less than 5 mass % was used, the resin composition was less thermally stable. Yet alternatively in Comparative Example 3 wherein a titanium oxide having a total deposited amount of alumina, silica, and zirconia of more than 15 mass % was used, the resin composition was thermally stable but less dispersible.

Alternatively in Comparative Example 5 wherein a titanium oxide having a total deposited amount of alumina, silica, and zirconia in the range of 5 to 15 mass % but a deposited amount of zirconia of less than 0.5 mass % was used, and also in Comparative Example 6 wherein a titanium oxide having an deposited amount of zirconia of 2.0 mass % or more was used, the resin compositions were both less dispersible.

In contrast, the resin films of Examples 1 to 4, which are included in the technical scope to the present invention, were superior in the pigment dispersibility and the thermal stability during molding processing to the resin films of Comparative Examples 1 to 6 described above. The results above show that, in production of the vinylidene fluoride-based resin film according to the present invention, dispersion insufficiency seldom occurs and pinhole generation is suppressed during processing and molding of the film even when the film is colored by addition of an inorganic pigment in a larger amount, and the film obtained is also superior in thermal stability.

### Industrial Applicability

The vinylidene fluoride-based resin film according to the present invention is superior in chemical resistance, weather resistance, and stain resistance and highly adhesive to other base materials, has a particularly favorable frosted low-gloss surface, and is superior in mechanical strength and thermal processability. For that reason, it is favorably suited for various applications including interior and exterior materials in buildings and automobile parts, particularly for decoration and improvement of design in applications demanding high weather resistance. Specifically, it is favorably used in applications including wall papers, interior and exterior parts of vehicles, interior and exterior materials of elevators, roof materials, wall materials, rainwater gutters, motor garages, arcades, sun rooms, agricultural materials, tent cloths, signboards, sings and marks, labels, marking films, furniture, home appliances, trays, roofing tiles, solar cells and window glasses.

## Claims

1. A vinylidene fluoride-based resin film, comprising
a vinylidene fluoride resin,
a methacrylate ester resin,
a titanium oxide surface-treated with alumina, silica, and zirconia, and
a polyethylene glycol fatty acid ester and/or the derivative thereof, wherein the total amount of alumina, silica, and zirconia deposited on the titanium oxide is 5 to 15 mass %, and the amount of zirconia deposited thereon is 0.5 mass % or more and less than 2.0 mass %.

2. The vinylidene fluoride-based resin film according to Claim 1,
wherein
the titanium oxide is contained in an amount of 10 to 25 parts by mass and the polyethylene glycol fatty acid ester and/or the derivative thereof in a total amount of 0.1 to 5 parts by mass,
with respect to 100 parts by mass of the resin component consisting of the vinylidene fluoride resin: 70 to 95 mass % and the methacrylate ester resin: 5 to 30 mass %.

3. The vinylidene fluoride-based resin film according to Claim 2, wherein the titanium oxide content is 12 to 20 parts by mass.

4. The vinylidene fluoride-based resin film according to any one of Claims 1 to 3, wherein the total amount of alumina, silica, and zirconia deposited on the titanium oxide is 6 to 12 mass %.

5. The vinylidene fluoride-based resin film according to any one of Claims 1 to 4, wherein the amounts of alumina and silica deposited on the titanium oxide are respectively 2.5 mass % or more and the amount of zirconia deposited thereon is 1.0 mass % or more and less than 2.0 mass %.

6. The vinylidene fluoride-based resin film according to any one of Claims 1 to 5, wherein the titanium oxide is surface-treated with an organic matter.

7. A solar cell back sheet, comprising the vinylidene fluoride-based resin film according to any one of Claims 1 to 6.

8. A solar cell module, comprising the solar cell back sheet according to Claim 7.

## Patentansprüche

1. Harzfilm auf Vinylidenfluoridbasis, umfasssend
ein Vinylidenfluoridharz,
ein Methacrylatestherharz,
eine Titanoxidoberfläche behandelt mit Aluminiumoxid, Siliziumoxid, und Zirkoniumdioxid und einem Polyethylenglycolfettsäureesther und/oder das Derivat davon, wobei die totale Menge von Aliminiumoxid, Siliziumoxid und Zirkoniumdioxid aufgetragen auf dem Titanoxid 5 bis 15 Massen-% ist, und die Menge von Zirkoniumdioxid darauf aufgetragen 0,5 Massen-% oder mehr und weniger als 2,0 Massen-% ist.

2. Harzfilm auf Vinylidenfluoridbasis nach Anspruch 1, wobei
das Titanoxid in einer Menge von 10 bis 25 Masseteilen und der Polyethylenglycolfettsäureesther und/oder das Derivat davon in einer Gesamtmenge von 0,1 bis 5 Masseteilen enthalten ist,
in Bezug auf 100 Masseteilen von der Harzkomponente bestehend aus dem Vinyldenfluoridharz: 70 bis 95 Massen-% und das Methacrylatestherharz: 5 bis 30 Massen-%.

3. Harzfilm auf Vinylidenfluoridbasis nach Anspruch 2, wobei der Titanoxidgehalt 12 bis 20 Masseteile ist.

4. Harzfilm auf Vinylidenfluoridbasis nach einem der Ansprüche 1 bis 3, wobei die Gesamtmenge von Aluminiumoxid, Siliziumoxid und Zirkoniumdioxid aufgetragen auf dem Titanoxid 6 bis 12 Massen-% ist.

5. Harzfilm auf Vinylidenfluoridbasis nach einem der Ansprüche 1 bis 4, wobei die Menge von Aluminiumoxid und Siliziumoxid aufgetragen auf dem Titanoxid jeweils 2,5 Massen-% oder mehr sind und die Menge von Zirkoniumdioxid darauf aufgetragen 1,0 Massen-% oder mehr und weniger als 2,0 Massen-% ist.

6. Harzfilm auf Vinylidenfluoridbasis nach einem der Ansprüche 1 bis 5, wobei das Titanoxid mit einem organischen Material oberflächenbehandelt ist.

7. Solarzellenrückseitenfolie umfassend den Harzfilm auf Vinylidenfluoridbasis nach einem der Ansprüche 1 bis 6.

8. Solarzellenmodul umfassend die Solarzellenrückseitenfolie nach Anspruch 7.

## Revendications

1. Film de résine à base de fluorure de vinylidène, comprenant :
une résine de fluorure de vinylidène,
une résine d'ester de méthacrylate,
un oxyde de titane traité en surface avec de l'alumine, de la silice et de la zircone, et
un ester d'acide gras de polyéthylène glycol et/ou le dérivé de celui-ci, dans lequel la quantité totale d'alumine, de silice et de zircone déposée sur l'oxyde de titane est de 5 % à 15 % en masse, et la quantité de zircone déposée sur l'oxyde de titane est supérieure ou égale à 0,5 % en masse et inférieure à 2,0 % en masse.

2. Film de résine à base de fluorure de vinylidène selon la revendication 1, dans lequel
l'oxyde de titane est contenu en une quantité de 10 à 25 parties en masse et l'ester d'acide gras de polyéthylène glycol et/ou le dérivé de celui-ci est contenu en une quantité totale de 0,1 à 5 parties en masse,
par rapport à 100 parties en masse du composant de résine consistant en la résine de fluorure de vinylidène : 70 % à 95 % en masse et de la résine d'ester de méthacrylate : 5 % à 30 % en masse.

3. Film de résine à base de fluorure de vinylidène selon la revendication 2, dans lequel la teneur en oxyde de titane est de 12 à 20 parties en masse.

4. Film de résine à base de fluorure de vinylidène selon l'une quelconque des revendications 1 à 3, dans lequel la quantité totale d'alumine, de silice et de zircone déposée sur l'oxyde de titane est de 6 % à 12 % en masse.

5. Film de résine à base de fluorure de vinylidène selon l'une quelconque des revendications 1 à 4, dans lequel les quantités d'alumine et de silice déposées sur l'oxyde de titane sont respectivement supérieures ou égales à 2,5 % en masse et la quantité de zircone déposée sur l'oxyde de titane est supérieure ou égale à 1,0 % en masse et inférieure à 2,0 % masse.

6. Film de résine à base de fluorure de vinylidène selon l'une quelconque des revendications 1 à 5, dans lequel l'oxyde de titane est traité en surface avec une matière organique.

7. Couche arrière de cellule solaire, comprenant le film de résine à base de fluorure de vinylidène selon l'une quelconque des revendications 1 à 6.

8. Module de cellule solaire, comprenant la couche arrière de cellule solaire selon la revendication 7.
